# EUROPEAN PATENT SPECIFICATION

(11) **EP 3 470 484 B1**
(45) Date of publication and mention of the grant of the patent: **29.04.2020**
(21) Application number: 18199851.9
(22) Date of filing: 11.10.2018
(51) Int. Cl.: C09D 183/06, C08G 77/14, C08L 83/06

(54) **COMPOSITION, ARTICLE, WINDOW FOR ELECTRONIC DEVICE, AND ELECTRONIC DEVICE**
ZUSAMMENSETZUNG, ARTIKEL, FENSTER FÜR ELEKTRONISCHE VORRICHTUNG UND ELEKTRONISCHE VORRICHTUNG
COMPOSITION, ARTICLE, FENÊTRE POUR DISPOSITIF ÉLECTRONIQUE ET DISPOSITIF ÉLECTRONIQUE

(30) Priority: 16.10.2017 KR 20170134031
(43) Date of publication of application: 17.04.2019
(73) Proprietor: Samsung Electronics Co., Ltd., Suwon-si, Gyeonggi-do 16677 (KR)
(72) Inventor: BAE, Jun Cheol, Gyeonggi-do (KR); HAM, Cheol, Gyeonggi-do (KR); MOON, Deuk Kyu, Seoul (KR); SEO, Byung Hwa, Gyeonggi-do (KR); LEE, Jae Jun, 16699 Gyeonggi-do (KR); CHO, Hyung-Soo, Gyeonggi-do (KR)
(74) Representative: Elkington and Fife LLP

(56) References cited:
- WO-A1-2008/087741
- WO-A1-2013/094585
- WO-A1-2015/053397
- US-A1- 2016 297 933

## Description

### FIELD OF THE INVENTION

A composition, an article, a window for an electronic device, and an electronic device are disclosed.

### BACKGROUND OF THE INVENTION

As portable electronic devices are manufactured into a smart phone, a tablet PC, or the like, having a display device, it is necessary for the display device used thereon to be flexible, such as being bendable, foldable, or rollable, as well as being slim and light.

Currently, the display devices mounted on portable electronic devices use rigid glass to protect the display module. However, the glass often lacks flexibility and thus may not be suitable for a flexible display device. Accordingly, there remains a need for a flexible transparent film as an alternative to glass.

### SUMMARY OF THE INVENTION

An embodiment provides a composition capable of improving flexibility and mechanical characteristics.

Another embodiment provides an article capable of improving flexibility and mechanical characteristics.

Yet another embodiment provides a window for an electronic device capable of improving flexibility and mechanical characteristics.

Still another embodiment provides an electronic device including the article or the window for an electronic device.

According to an embodiment, a composition includes a cationic polymerizable organic compound and an organosiloxane including at least one silsesquioxane, wherein each silsesquioxane independently includes an inorganic core having a SiO_{3/2} moiety and an organic group having a cationic polymerizable functional group, and wherein the organic group in the organosiloxane includes a first organic group represented by Chemical Formula 1 and a second organic group represented by Chemical Formula 2.

Chemical Formula 1 R¹-(CH₂)ₙ₁-*

Chemical Formula 2 R²-(CH₂)ₙ₂-*

In Chemical Formula 1 or 2,
R¹ and R² are each independently the cationic polymerizable functional group,
n1 is an integer ranging from 1 to 3, and
n2 is an integer of 4 or greater.

The organosiloxane may include a first silsesquioxane including a first inorganic core having a SiO_{3/2} moiety, and the first organic group linked with the first inorganic core; and a second silsesquioxane including a second inorganic core having a SiO_{3/2} moiety, and the second organic group linked with the second inorganic core.

The first silsesquioxane and the second silsesquioxane may be in a weight ratio of about 9:1 to about 1:9.

The first silsesquioxane may be represented by Chemical Formula 3 and the second silsesquioxane may be represented by Chemical Formula 4.

Chemical Formula 3 (R^{a}R^{b}R^{c}SiO_{1/2})_{M1}(R^{d}R^{e}SiO_{2/2})_{D1}(R^{f}SiO_{3/2})_{T1a}(R^{g}SiO_{3/2})_{T1b}(R^{h}SiO_{3/2})_{T1c}(SiO _{4/2})_{Q1}

Chemical Formula 4 (RⁱR^{j}R^{k}SiO_{1/2})_{M2}(R^{l}R^{m}SiO_{2/2})_{D2}(RⁿSiO_{3/2})_{T2a}(R^{o}SiO_{3/2})_{T2b}(R^{p}SiO_{3/2})_{T2c}(SiO_{4 /2})_{Q2}

In Chemical Formula 3 or 4,
R^{a} to R^{g} and Rⁱ to R^{o} are each independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, a substituted or unsubstituted C1 to C30 alkoxy group, a substituted or unsubstituted C1 to C30 carbonyl-containing group, a hydroxy group, or a combination thereof,
R^{h} is the first organic group represented by Chemical Formula 1,
R^{p} is the second organic group represented by Chemical Formula 2,
0≤M1≤0.4, 0≤D1≤0.4, 0≤T1a<1, 0≤T1b<1, 0<T1c≤1, and 0≤Q1≤0.4, provided that 0.6≤T1a+T1b+T1c≤1,
0≤M2≤0.4, 0≤D2≤0.4, 0≤T2a<1, 0≤T2b<1, 0<T2c≤1, and 0≤Q2≤0.4, provided that 0.6≤T2a+T2b+T2c≤1,
M1+D1+T1a+T1b+T1c+Q1=1, and
M2+D2+T2a+T2b+T2c+Q2=1.

The organosiloxane may include a silsesquioxane including a third inorganic core having a SiO_{3/2} moiety and the first organic group and the second organic group each linked with the third inorganic core.

The silsesquioxane may be represented by Chemical Formula 5.

Chemical Formula 5 (R^{q}R^{r}R^{s}SiO_{1/2})_{M3}(R^{t}R^{u}SiO_{2/2})_{D3}(R^{v}SiO_{3/2})_{T3a}(R^{w}SiO_{3/2})_{T3b}(R^{x}SiO_{3/2})_{T3c}(R^{y}S iO_{3/2})_{T3d}(SiO_{4/2})_{Q3}

In Chemical Formula 5,
R^{q} to R^{w} are each independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, a substituted or unsubstituted C1 to C30 alkoxy group, a substituted or unsubstituted C1 to C30 carbonyl-containing group, a hydroxy group, or a combination thereof,
R^{x} is the first organic group represented by Chemical Formula 1,
R^{y} is the second organic group represented by Chemical Formula 2,
0≤M3≤0.4, 0≤D3≤0.4, 0≤T3a<1, 0≤T3b<1, 0<T3c<1, 0<T3d<1, and 0≤Q3≤0.4, provided that 0.6≤T3a+T3b+T3c+T3d≤1, and
M3+D3+T3a+T3b+T3c+T3d+Q3=1.

The n1 of Chemical Formula 1 may be 1, 2, or 3, and the n2 of Chemical Formula 2 may be an integer of 6 to 12.

The cationic polymerizable functional group may include a substituted or unsubstituted glycidyl group, a substituted or unsubstituted glycidyl ether group, a substituted or unsubstituted glycidyl ester group, a substituted or unsubstituted oxetanyl group, a substituted or unsubstituted C3 to C30 epoxyalkyl group, or a combination thereof.

The first organic group may be represented by Chemical Formula 1a, and the second organic group may be represented by Chemical Formula 2a.

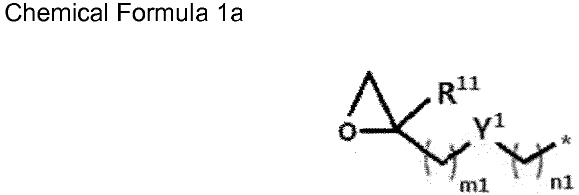

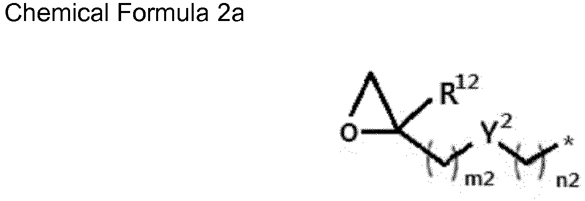

In Chemical Formula 1a or 2a,
Y¹ and Y² are each independently O, C(=O), C(=O)O, or OC(=O),
R¹¹ and R¹² are each independently hydrogen or a methyl group,
m1 and m2 are each independently an integer ranging from 1 to 3,
n1 is an integer ranging from 1 to 3, and
n2 is an integer of 4 or greater.

The cationic polymerizable organic compound may include a functional group that is a substituted or unsubstituted glycidyl group, a substituted or unsubstituted glycidyl ether group, a substituted or unsubstituted glycidyl ester group, a substituted or unsubstituted oxetanyl group, a substituted or unsubstituted C3 to C30 epoxyalkyl group, a substituted or unsubstituted vinyl group, a substituted or unsubstituted vinyl ether group, a substituted or unsubstituted styrenyl group, or a combination thereof.

The cationic polymerizable organic compound may be represented by Chemical Formula A or B.

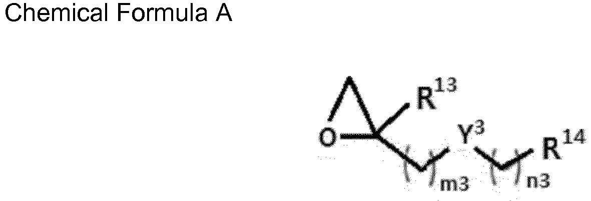

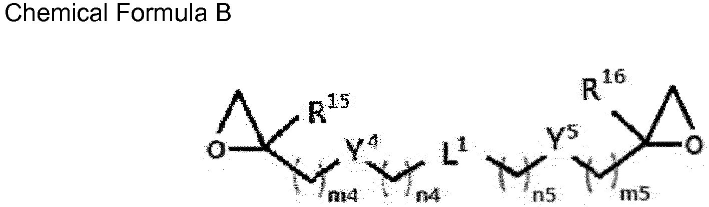

In Chemical Formula A or B,
Y³ to Y⁵ are each independently O, C(=O), C(=O)O, or OC(=O),
R¹³, R¹⁵, and R¹⁶ are each independently hydrogen or a methyl group,
R¹⁴ is a substituted or unsubstituted C1 to C30 alkyl group, a substituted or unsubstituted C3 to C30 cycloalkyl group, a substituted or unsubstituted C2 to C30 heterocycloalkyl group, a substituted or unsubstituted C6 to C30 aryl group, a substituted or unsubstituted C3 to C30 heteroaryl group, or a combination thereof,
L¹ is a substituted or unsubstituted C1 to C30 alkylene group, a substituted or unsubstituted C3 to C30 cycloalkylene group, a substituted or unsubstituted C2 to C30 heterocycloalkylene group, a substituted or unsubstituted C6 to C30 arylene group, a substituted or unsubstituted C3 to C30 heteroarylene group, or a combination thereof,
m3 to m5 are each independently an integer ranging from 1 to 3, and
n3 to n5 are each independently an integer ranging from 0 to 10.

An amount by weight of the organosiloxane may be equal to or greater than an amount by weight of the cationic polymerizable organic compound.

The cationic polymerizable organic compound may be in an amount of about 5 parts by weight to about 50 parts by weight, based on a total amount of 100 parts by weight of the cationic polymerizable organic compound and the organosiloxane, and the organosiloxane may be in an amount of about 50 parts by weight to about 95 parts by weight, based on a total amount of 100 parts by weight of the cationic polymerizable organic compound and the organosiloxane.

The composition may further include a solvent, and wherein a total amount of the cationic polymerizable organic compound and the organosiloxane may be about 10 weight percent (wt%) to about 80 wt%, based on a total weight of the composition.

The composition may further include at least one of a reaction initiator, a fluorine compound, and a silicon-based compound.

According to another embodiment, an article includes a cured product of the composition.

According to yet another embodiment, a film includes a cured product of the composition.

According to still another embodiment, a window for an electronic device includes a polymer substrate; and the film disposed on the polymer substrate.

According to further another embodiment, an electronic device includes the film.

According to further another embodiment, an electronic device includes the window for an electronic device.

### BRIEF DESCRIPTION OF THE DRAWINGS

These and/or other aspects will become more apparent and more readily appreciated from the following description of exemplary embodiments, taken with reference to the accompanying drawings, wherein:
FIG. 1 is a cross-sectional view of a window for an electronic device according to an embodiment,
FIG. 2 is a cross-sectional view of a window for an electronic device according to another embodiment,
FIG. 3 is a cross-sectional view of a display device according to an embodiment,
FIG. 4 is a cross-sectional view of a display device according to another embodiment,
FIGS. 5A and 5B are graphs of intensity (arbitrary units, a.u) versus chemical shift (δ, parts per million (ppm)) for the silsesquioxane obtained in Synthesis Example 1, and
FIGS. 6A and 6B are graphs of intensity (au) versus chemical shift (δ, ppm) for the silsesquioxane obtained in Synthesis Example 2.

### DETAILED DESCRIPTION OF THE EMBODIMENTS

Hereinafter, exemplary embodiments of the present disclosure will be described in more detail so that a person skilled in the art would understand the same. This disclosure, however, may be embodied in many different forms and should not be construed as limited to the exemplary embodiments set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

In the drawings, the thickness of layers, films, panels, regions, etc., are illustrated in an exaggerated manner for clarity and ease of description thereof. Like reference numerals designate like elements throughout the specification. It will be understood that when an element ,layer, film, region, or substrate is referred to as being "on" another element, layer, film, region, or substrate, it may be directly on the other element, layer, film, region, or substrate, or intervening elements, layers, films, regions, or substrates may also be present therebetween. In contrast, when an element, layer, film, region, or substrate is referred to as being "directly on" another element, layer, film, region, or substrate, there are no intervening elements, layers, films, regions, or substrates present. Further when an element, layer, film, region, or substrate is referred to as being "below" another element, layer, film, region, or substrate, it may be directly below the other element, layer, film, region, or substrate, or intervening elements, layers, films, regions, or substrates may be present therebetween. Conversely, when an element, layer, film, region, or substrate is referred to as being "directly below" another element, layer, film, region, or substrate, there are no intervening elements, layers, films, regions, or substrates therebetween.

The spatially relative terms "lower" or "bottom" and "upper" or "top", "below", "beneath", "under", "above", and the like, may be used herein for ease of description to describe the relationship between one element or component and another element or component as illustrated in the drawings. It will be understood that the spatially relative terms are intended to encompass different orientations of the device in use or operation, in addition to the orientation depicted in the drawings. For example, in the case where a device illustrated in the drawings is turned over, elements described as being on the "lower" side of other elements, or "below" or "beneath" another element would then be oriented on "upper" sides of the other elements, or "above" another element. Accordingly, the illustrative term "below" or "beneath" may include both the "lower" and "upper" orientation positions, depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below, and thus the spatially relative terms may be interpreted differently depending on the orientations described.

In the drawings, exemplary embodiments are described with reference to cross section illustrations that are schematic illustrations of idealized embodiments, where parts having no relationship with the description are omitted for clarity of the embodiments, and the same or similar constituent elements are indicated by the same reference numeral throughout the specification. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." It will be further understood that the terms "comprises," "comprising," "includes" and/or "including," when used in this specification, specify the presence of stated features, integers, steps, operations, elements, and/or components, but do not preclude the presence or addition of one or more other features, integers, steps, operations, elements, components, and/or groups thereof.

It will be understood that, although the terms "first," "second," "third," and the like, may be used herein to describe various elements, these elements should not be limited by these terms. These terms are only used to distinguish one element from another element. Thus, "a first element" discussed below could be termed "a second element" or "a third element," and "a second element" and "a third element" may be termed likewise without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined in the present specification.

Hereinafter, a 'combination'refers to a mixture of two or more or a stack structure of two or more.

As used herein, when a definition is not otherwise provided, "substituted" refers to a group or compound wherein at least one of the hydrogen atoms thereof is substituted with a halogen atom (F, CI, Br, or I), a hydroxy group, an alkoxy group, a nitro group, a cyano group, an amino group, an azido group, an amidino group, a hydrazino group, a hydrazono group, a carbonyl group, a carbamyl group, a thiol group, an ester group, a carboxylic acid group or a salt thereof, a sulfonic acid group or a salt thereof, a phosphoric acid group or a salt thereof, a C1 to C20 alkyl group, a C2 to C20 alkenyl group, a C2 to C20 alkynyl group, a C6 to C30 aryl group, a C7 to C30 arylalkyl group, a C1 to C30 alkoxy group, a C1 to C20 heteroalkyl group, a C3 to C20 heteroarylalkyl group, a C3 to C30 heteroaryl group, a C3 to C30 cycloalkyl group, a C3 to C15 cycloalkenyl group, a C6 to C15 cycloalkynyl group, a C3 to C30 heterocycloalkyl group, or a combination thereof. "Substituted" is intended to be non-limiting and include inorganic substituents or organic substituents.

A "unsubstituted group" may also be referred to herein as an equivalent term "non-substituted group" which refers to the original group in which a hydrogen within that group is not replaced by a non-hydrogen moiety.

As used herein, when a definition is not otherwise provided, the term "hetero" refers to a compound or group including one to three heteroatoms that are N, O, S, P, and/or Si .

As used herein, when a definition is not otherwise provided, the term "hydrocarbon" refers to a C1 to C40 alkyl, a C2 to C40 alkenyl, a C2 to C40 alkynyl, a C3 to C40 cycloalkyl, a C3 to C40 cycloalkenyl, a C3 to C40 cycloalkynyl, or a C6 to C40 aryl.

As used herein, when a definition is not otherwise provided, the term "alkyl group" refers to a group derived from a straight or branched chain saturated aliphatic hydrocarbon having the specified number of carbon atoms and having a valence of at least one.

As used herein, when a definition is not otherwise provided, the term "alkenyl group" refers to a straight or branched chain, monovalent hydrocarbon group having at least one carbon-carbon double bond.

As used herein, when a definition is not otherwise provided, the term "alkynyl group" refers to a straight or branched chain, monovalent hydrocarbon group having at least one carbon-carbon triple bond.

As used herein, when a definition is not otherwise provided, an alkyl group, an alkenyl group, or an alkynyl group may be linear or branched. Specific examples of the alkyl group may be a methyl group, an ethyl group, an isopropyl group, a tert-butyl group, an n-octyl group, an n-decyl group, an n-hexadecyl group, and the like. Specific examples of the alkenyl group may be a vinyl group, an allyl group, a 2-butenyl group, a 3-pentenyl group, and the like. Specific examples of the alkynyl group may be a propargyl group, a 3-pentynyl group, and the like.

As used herein, when a definition is not otherwise provided, the term "alkoxy group" refers to "alkyl-O-", wherein the term "alkyl" has the same meaning as described above.

As used herein, when a definition is not otherwise provided, the term "cycloalkyl group" refers to a monovalent group having one or more saturated rings in which all ring members are carbon.

As used herein, when a definition is not otherwise provided, the term "aryl", which is used alone or in combination, refers to an aromatic hydrocarbon containing at least one ring and having the specified number of carbon atoms. The term "aryl" may be construed as including a group with an aromatic ring fused to at least one cycloalkyl ring.

As used herein, when a definition is not otherwise provided, the term "arylalkyl" refers to an alkyl group substituted with an aryl group.

As used herein, when a definition is not otherwise provided, the term "heteroaryl" refers to a functional group obtained by removal of a hydrogen from an heteroaromatic ring, containing one to three heteroatoms selected from the group consisting of N, O, S, Si, and P as ring-forming elements, and optionally substituted with one or more substituents where indicated.

As used herein, when a definition is not otherwise provided, the term "heteroarylalkyl" refers to an alkyl group substituted with a heteroaryl group.

As used herein, the terms "alkylene", "cycloalkylene", "arylene", and "heteroarylene" refer to a divalent group respectively derived from an alkyl group, a cycloalkyl group, an aryl group, and a heteroaryl group as defined above.

As used herein, when a definition is not otherwise provided, the term "amine group" refers to group having formula NRR' wherein R and R' are independently hydrogen, a C1 to C20 alkyl group, or a C6 to C30 aryl group.

As used herein, when a definition is not otherwise provided, the term "carbonyl-containing group" refers to R(C=O)- where R is hydrogen, a C1 to C20 alkyl group, or a C6 to C30 aryl group. The carbonyl-containing group further includes a carboxylic acid (where R is OH), a substituted or unsubstituted carboxylate salt (where R is -O⁻Z⁺, where Z is a substituted or unsubstituted cation), a substituted or unsubstituted ester group, a substituted or unsubstituted amide, and a substituted or unsubstituted imide group.

When a group containing a specified number of carbon atoms is substituted with any of the groups listed in the preceding paragraph, the number of carbon atoms in the resulting "substituted" group is defined as the sum of the carbon atoms contained in the original (unsubstituted) group and the carbon atoms (if any) contained in the substituent. For example, when the term "substituted C1 to C20 alkyl" refers to a C1 to C20 alkyl group substituted with a C6 to C20 aryl group, the total number of carbon atoms in the resulting aryl substituted alkyl group is C7 to C40.

An asterisk (i.e., "*") denotes a point of attachment, e.g., a position linked to the same or different atom or chemical formula.

Hereinafter, a composition according to an embodiment is described.

A composition according to an embodiment includes a cationic polymerizable organic compound and an organosiloxane.

The cationic polymerizable organic compound is a hydrocarbon having a functional group polymerizable according to a cationic polymerization mechanism that may be a monomer, an oligomer, and/or a polymer. The cationic polymerizable organic compound may include, for example, a functional group that is a substituted or unsubstituted epoxy group, a substituted or unsubstituted oxetanyl group, a substituted or unsubstituted vinyl group, a substituted or unsubstituted styrenyl group, or a combination thereof, for example a functional group selected from a substituted or unsubstituted glycidyl group, a substituted or unsubstituted glycidyl ether group, a substituted or unsubstituted glycidyl ester group, a substituted or unsubstituted C3 to C30 epoxyalkyl group, a substituted or unsubstituted oxetanyl group, a substituted or unsubstituted vinyl group, a substituted or unsubstituted vinyl ether group, a substituted or unsubstituted styrenyl group, or a combination thereof, but is not limited thereto.

For example, the cationic polymerizable organic compound may have one functional group, or two or more functional groups that may be a substituted or unsubstituted glycidyl ether group, a substituted or unsubstituted glycidyl ester group, a substituted or unsubstituted epoxycyclohexyl group, and/or a substituted or unsubstituted oxetanyl group.

For example, the cationic polymerizable organic compound may be represented by Chemical Formula A or B, but is not limited thereto.

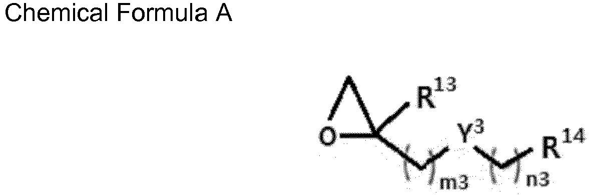

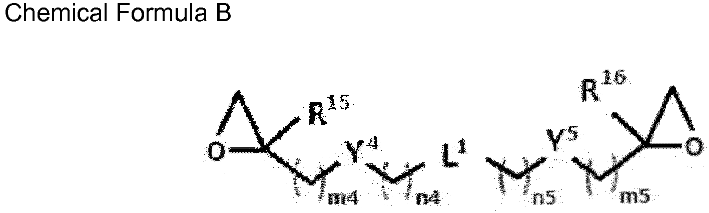

In Chemical Formula A or B,
Y³ to Y⁵ are each independently O, C(=O), C(=O)O, or OC(=O),
R¹³, R¹⁵, and R¹⁶ are each independently hydrogen or a methyl group,
R¹⁴ is a substituted or unsubstituted C1 to C30 alkyl group, a substituted or unsubstituted C3 to C30 cycloalkyl group, a substituted or unsubstituted C2 to C30 heterocycloalkyl group, a substituted or unsubstituted C6 to C30 aryl group, a substituted or unsubstituted C3 to C30 heteroaryl group, or a combination thereof,
L¹ is a substituted or unsubstituted C1 to C30 alkylene group, a substituted or unsubstituted C3 to C30 cycloalkylene group, a substituted or unsubstituted C2 to C30 heterocycloalkylene group, a substituted or unsubstituted C6 to C30 arylene group, a substituted or unsubstituted C3 to C30 heteroarylene group, or a combination thereof,
m3 to m5 are each independently an integer ranging from 1 to 3, and
n3 to n5 are each independently an integer ranging from 0 to 10.

For example, in Chemical Formula A, R¹⁴ may be a substituted or unsubstituted C1 to C30 alkyl group, a substituted or unsubstituted C3 to C30 cycloalkyl group, or a substituted or unsubstituted C6 to C30 aryl group.

For example, in Chemical Formula A, R¹⁴ may be a substituted or unsubstituted C3 to C30 cycloalkyl group, or a substituted or unsubstituted C6 to C30 aryl group, and for example R¹⁴ may be a substituted or unsubstituted phenyl group, a substituted or unsubstituted naphthyl group, a substituted or unsubstituted biphenyl group, or a substituted or unsubstituted cyclohexyl group, but is not limited thereto.

For example, in Chemical Formula B, L¹ may be a substituted or unsubstituted C1 to C30 alkylene group, a substituted or unsubstituted C3 to C30 cycloalkylene group, or a substituted or unsubstituted C6 to C30 arylene group.

For example, in Chemical Formula B, L¹ may be a substituted or unsubstituted C3 to C30 cycloalkylene group, or a substituted or unsubstituted C6 to C30 arylene group.

The cationic polymerizable organic compound may include one type of cationic polymerizable functional group or two or more types of cationic polymerizable functional groups. In an embodiment, the cationic polymerizable organic compound includes a substituted or unsubstituted epoxy group and a substituted or unsubstituted vinyl group.

The organosiloxane includes at least one silsesquioxane including an organic group having a cationic polymerizable functional group.

The silsesquioxane is an organic/inorganic compound having a three dimensional reticular structure and an inorganic core of a SiO_{3/2} moiety and may include, for example, a closed-caged silsesquioxane, an open-caged silsesquioxane, or a combination thereof.

Each silsesquioxane may have an inorganic core having a SiO_{3/2} moiety and organic groups linked with the inorganic core. The organic groups may be bonded to Si of the SiO_{3/2} moiety and in addition, the organic groups may be the same or different from one another.

The organic groups may have at least one cationic polymerizable functional group. The cationic polymerizable functional group may be polymerized according to a cationic polymerization mechanism without a particular limit.

The cationic polymerizable functional group may be, for example, a substituted or unsubstituted epoxy group, a substituted or unsubstituted oxetanyl group, a substituted or unsubstituted vinyl group, a substituted or unsubstituted styrenyl group, or a combination thereof, and for example a substituted or unsubstituted glycidyl group, a substituted or unsubstituted glycidyl ether group, a substituted or unsubstituted glycidyl ester group, a substituted or unsubstituted C3 to C30 epoxyalkyl group, a substituted or unsubstituted oxetanyl group, a substituted or unsubstituted vinyl group, a substituted or unsubstituted vinyl ether group, a substituted or unsubstituted styrenyl group, or a combination thereof, but is not limited thereto. For example, the cationic polymerizable functional group may be a substituted or unsubstituted glycidyl ether group, a substituted or unsubstituted glycidyl ester group, a substituted or unsubstituted epoxycyclohexyl group, a substituted or unsubstituted oxetanyl group, or a combination thereof, but is not limited thereto.

The organosiloxane may include a silsesquioxane with two organic groups having a different chain length from one another, for example, an organic group having a short chain length and an organic group having a long chain length.

The organic groups having a different chain length from one another may include, for example, a first organic group represented by Chemical Formula 1 and a second organic group represented by Chemical Formula 2.

Chemical Formula 1 R¹-(CH₂)ₙ₁-*

Chemical Formula 2 R²-(CH₂)ₙ₂-*

In Chemical Formula 1 or 2,
R¹ and R² are each independently a cationic polymerizable functional group,
n1 is an integer ranging from 1 to 3, and
n2 is an integer of 4 or greater.

In other words, the first organic group represented by Chemical Formula 1 may be an organic group having a short chain length, and the second organic group represented by Chemical Formula 2 may be an organic group having a long chain length.

The first organic group may be, for example, represented by Chemical Formula 1a and the second organic group may be, for example, represented by Chemical Formula 2a, but are not limited thereto.

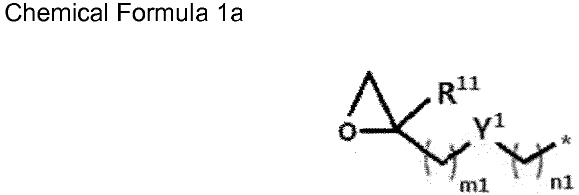

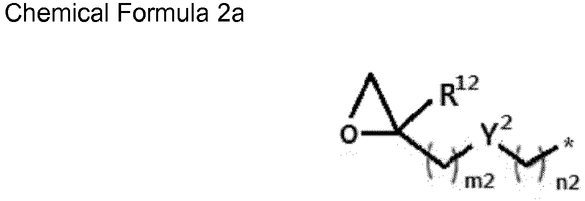

In Chemical Formula 1 a or 2a,
Y¹ and Y² are each independently O, C(=O), C(=O)O, or OC(=O),
R¹¹ and R¹² are each independently hydrogen or a methyl group,
m1 and m2 are each independently an integer ranging from 1 to 3,
n1 is an integer ranging from 1 to 3, and
n2 is an integer of 4 or greater.

In an embodiment, the n1 of Chemical Formulae 1 and 1a may be 1, 2, or 3, and the n2 of Chemical Formulae 2 and 2a may be an integer of 5 or greater.

In another embodiment, the n1 of Chemical Formulae 1 and 1a may be 1, 2, or 3, and the n2 of Chemical Formulae 2 and 2a may be an integer of 6 or greater.

In still another embodiment, the n1 of Chemical Formulae 1 and 1a may be 1, 2, or 3, and the n2 of Chemical Formulae 2 and 2a may be an integer of 6 to 30.

In an embodiment, the n1 of Chemical Formulae 1 and 1a may be 1, 2, or 3, and the n2 of Chemical Formulae 2 and 2a may be an integer of 6 to 25.

In another embodiment, the n1 of Chemical Formulae 1 and 1a may be 1, 2, or 3, and the n2 of Chemical Formulae 2 and 2a may be an integer of 6 to 20.

In still another embodiment, the n1 of Chemical Formulae 1 and 1a may be 1, 2, or 3, and the n2 of Chemical Formulae 2 and 2a may be an integer of 6 to 15.

In yet another embodiment, the n1 of Chemical Formulae 1 and 1a may be 1, 2, or 3, and the n2 of Chemical Formulae 2 and 2a may be an integer of 6 to 12.

In some embodiments, the n1 of Chemical Formulae 1 and 1a may be 1, 2, or 3, and the n2 of Chemical Formulae 2 and 2a may be an integer of 6 to 10.

The organic group having a short chain length and the organic group having a long chain length may be for example bonded to different SiO_{3/2} moieties or to one single SiO_{3/2} moiety.

For example, the organosiloxane may include the first silsesquioxane including the organic group having a short chain length and the second silsesquioxane including the organic group having a long chain length. The first silsesquioxane may include a first inorganic core having a SiO_{3/2} moiety and the first organic group having a short chain length and linked with the first inorganic core, and the second silsesquioxane may include a second inorganic core having a SiO_{3/2} moiety and the second organic group having a long chain length and linked with the second inorganic core. The first silsesquioxane may include at least one the first organic group and the second silsesquioxane may include at least one the second organic group.

The first silsesquioxane and the second silsesquioxane may be present as a mixture in the composition and may be, for example, included in a weight ratio of about 9:1 to about 1:9.

The first inorganic core and the second inorganic core may be the same or different and may independently include a SiO_{3/2} moiety, and each may independently further include optionally SiO_{1/2}, SiO_{2/2}, and/or SiO_{4/2} moieties.

The first silsesquioxane may be, for example, represented by Chemical Formula 3, and the second silsesquioxane may be, for example, represented by Chemical Formula 4.

Chemical Formula 3 (R^{a}R^{b}R^{c}SiO_{1/2})_{M1}(R^{d}R^{e}SiO_{2/2})_{D1}(R^{f}SiO_{3/2})_{T1}(R^{g}SiO_{3/2})_{T1b}(R^{h}SiO_{3/2})_{T1c}(SiO_{4/2})_{Q1}

Chemical Formula 4 (RⁱR^{j}R^{k}SiO_{1/2})_{M2}(R^{l}R^{m}SiO_{2/2})_{D2}(RⁿSiO_{3/2})_{T2a}(R^{o}SiO_{3/2})_{T2b}(R^{p}SiO_{3/2})_{T2c}(SiO_{4/2})_{Q2}

In Chemical Formula 3 or 4,
R^{a} to R^{g} and Rⁱ to R^{o} are each independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group,a substituted or unsubstituted C2 to C30 alkynyl group, a substituted or unsubstituted C1 to C30 alkoxy group, a substituted or unsubstituted C1 to C30 carbonyl-containing group, a hydroxy group, or a combination thereof,
R^{h} is the first organic group represented by Chemical Formula 1,
R^{p} is the second organic group represented by Chemical Formula 2,
0≤M1≤0.4, 0≤D1≤0.4, 0≤T1a<1, 0≤T1b<1, 0<T1c≤1, and 0≤Q1≤0.4, provided that 0.6≤T1a+T1b+T1c≤1,
0≤M2≤0.4, 0≤D2≤0.4, 0≤T2a<1, 0≤T2b<1, 0<T2c≤1, and 0≤Q2≤0.4, provided that 0.6≤T2a+T2b+T2c≤1,
M1+D1+T1a+T1b+T1c+Q1=1, and
M2+D2+T2a+T2b+T2c+Q2=1.

The first silsesquioxane and the second silsesquioxane may be randomly distributed in a composition, and without being bound by theory, the first silsesquioxane having a short chain length provides a hard film during a curing process and thus may improve mechanical characteristics such as scratch resistance characteristics, while the second silsesquioxane having a long chain length provides flexibility and thus may improve flexibility of a cured product. Accordingly, the cured product of the composition may be provided with improved mechanical characteristics and the flexibility, simultaneously.

In another embodiment, the organosiloxane may include a silsesquioxane including both the organic group having a short chain length and the organic group having a long chain length. In other words, both of the organic groups are linked with the same silsesquioxane.

The silsesquioxane may, for example, have a third inorganic core having a SiO_{3/2} moiety and two organic groups linked with the third inorganic core, and the organic groups may include the first organic group having a short chain length and the second organic group having a long chain length.

The silsesquioxane may be, for example, represented by Chemical Formula 5

Chemical Formula 5 (R^{q}R^{r}R^{s}SiO_{1/2})_{M3}(R^{t}R^{u}SiO_{2/2})_{D3}(R^{v}SiO_{3/2})_{T3a}(R^{w}SiO_{3/2})_{T3b}(R^{x}SiO_{3/2})_{T3c}(R^{y}S iO_{3/2})_{T3d}(SiO_{4/2})_{Q3}

In Chemical Formula 5,
R^{q} to R^{w} are each independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, a substituted or unsubstituted C1 to C30 alkoxy group, a substituted or unsubstituted C1 to C30 carbonyl-containing group, a hydroxy group, or a combination thereof,
R^{x} is the first organic group represented by Chemical Formula 1,
R^{y} is the second organic group represented by Chemical Formula 2,
0≤M3≤0.4, 0≤D3≤0.4, 0≤T3a<1, 0≤T3b<1, 0<T3c<1, 0<T3d<1, and 0≤Q3≤0.4, provided that 0.6≤T3a+T3b+T3c+T3d≤1, and
M3+D3+T3a+T3b+T3c+T3d+Q3=1.

The silsesquioxane includes the organic group having a short chain length and the organic group having a long chain length, and thus may have flexibility as well as provide a hard film and resultantly provide a cured product of a composition with improved mechanical characteristics and flexibility, simultaneously.

The weight amount of the organosiloxane may be equal to or greater than the weight amount of the cationic polymerizable organic compound in the composition. For example, the cationic polymerizable organic compound may be included in the composition in an amount of about 5 parts by weight to about 50 parts by weight, based on a total amount of 100 parts by weight of the cationic polymerizable organic compound and the organosiloxane, and the organosiloxane may be included in the composition in an amount of about 50 parts by weight to about 95 parts by weight, based on a total amount of 100 parts by weight of the cationic polymerizable organic compound and the organosiloxane.

The composition may further include various additives, for example, a surface characteristic controlling agent, a reaction initiator, a polymerization promoter, an ultraviolet (UV) absorber, an antistatic agent, and the like, but is not limited thereto.

The surface characteristic controlling agent may include, for example, a fluorine compound, a silicon-based compound, or a combination thereof, but is not particularly limited thereto.

The silicon-based compound may be, for example, a polydimethylsiloxane, a polymethylphenylsiloxane, cyclicpolydimethylsiloxane, a polymethylhydrogensiloxane, a polyether modified polydimethylsiloxane copolymer, a polyester modified polydimethylsiloxane copolymer, a polyfluoro dimethylsiloxane copolymer, an amino modified polydimethylsiloxane copolymer, or a combination thereof, but is not limited thereto.

The surface characteristic controlling agent may be included in the composition an amount of about 0.01 to 5 parts by weight, for example, about 0.05 to 3 parts by weight, or about 0.05 to 1 part by weight, based on 100 parts by weight of a total amount of the cationic polymerizable organic compound and the organosiloxane.

The reaction initiator may be, for example, a photocuring reaction initiator or a thermally curing reaction initiator. The reaction initiator may be, for example, a cationic polymerization initiator, for example a cationic photopolymerization initiator or a cationic thermally curing initiator.

The cationic photopolymerization initiator may be, for example, a compound including an onium salt, for example a compound including diphenyliodonium, 4-methoxydiphenyliodonium, bis (4-methylphenyl)iodonium, bis (4-t-butylphenyl)iodonium, bis(dodecylphenyl)iodonium, triphenylsulfonium, diphenyl-4-thiophenoxyphenylsulfonium, bis[4-diphenylsulfonio]phenyl]sulfide, bis[4-(di(4-(2-hydroxyethyl)phenyl)sulfonio)-phenyl]sulfide, or a combination thereof, but is not limited thereto. The compound including the onium salt may generate an acid after a photo-reaction.

The reaction initiator may be included in the composition in an amount of about 0.01 parts by weight to about 20 parts by weight, for example, about 0.1 parts by weight to 10 parts by weight, or about 0.1 parts by weight to about 5 parts by weight, based on a total amount of 100 parts by weight of the cationic polymerizable organic compound and the organosiloxane.

The polymerization promoter may be, for example, 9,10-dimethoxy-2-ethyl-anthracene, 9,10-diethoxyanthracene, 2,4-diethylthioxanthone, or a combination thereof, but is not limited thereto. The polymerization promoter may be included in a trace amount.

The ultraviolet (UV) absorber may be, for example, a benzophenone-based compound, a triazine-based compound, a benzotriazole-based compound, a metal oxide, or a combination thereof, but is not limited thereto. The ultraviolet (UV) absorber may be included in a trace amount.

The antistatic agent may be, for example, pyridinium, imidazolium, phosphonium, ammonium, a lithium salt of bis(trifluoromethane sulfonyl)imide, a lithium salt of bis(trifluorosulfonyl)imide, or a combination thereof, but is not limited thereto.

The composition may further include a solvent that is capable of dissolving or dispersing the above components.

The solvent is not particularly limited, as long as it dissolves and/or disperses the above components, and may be, for example, one or more of water; an alcohol solvent such as methanol, ethanol, n-propyl alcohol, isopropyl alcohol, n-butanol, isobutanol, t-butanol, propylene glycol, propylene glycolmethylether, ethylene glycol, and the like; an aliphatic hydrocarbon solvent such as hexane, heptane, and the like; an aromatic or heteroaromatic hydrocarbon solvent such as toluene, pyridine, quinoline, anisole, mesitylene, xylene, and the like; a ketone-based solvent such as methyl isobutyl ketone, 1-methyl-2-pyrrolidinone (NMP), cyclohexanone, acetone, and the like; an ether-based solvent such as tetrahydrofuran, isopropyl ether, and the like; an acetate-based solvent such as ethyl acetate, butyl acetate, propylene glycol methyl ether acetate, and the like; an amide-based solvent such as dimethyl acetamide, dimethyl formamide (DMF), and the like; a nitrile-based solvent such as acetonitrile, benzonitrile, and the like; or a mixture of the solvents, but is not limited thereto.

The solvent may be included in a balance amount except the solid components.

The above cationic polymerizable organic compound and the organosiloxane may be included in the composition in an amount of about 5 to 95 wt%, for example about 5 to 90 wt%, about 10 to 85 wt%, or about 10 to 80 wt%, based on a total amount of the composition including a solvent.

The composition may be formed into a cured product such as a film through coating, drying, and curing.

The composition may be, for example, coated through a solution process, for example, spin coating, slit coating, bar coating, dip coating, spray coating, inkjet printing, or the like, but is not limited thereto.

The drying may be, for example, performed at about 70 °C to about 150 °C, and may be performed once or more than once.

The curing may be photo curing and/or thermal curing. The photo curing may be, for example, performed by using a xenon lamp, a high pressure mercury lamp, a metal halide lamp, and the like, and herein, a light dose and radiation time may be adjusted, as necessary. The thermal curing may be, for example, performed at about 80 °C to about 200 °C, and herein, heat treatment temperature and time may be adjusted, as necessary.

The cured product may be additionally heat-treated after the curing, and the heat treatment may be, for example, performed at about 50 °C to about 200 °C, for example, about 70 °C to about 180 °C, and for example, about 80 °C to about 160 °C.

The cured product may be transparent and satisfy, for example, a light transmittance of greater than or equal to about 80 %, haze of less than or equal to about 2%, and a yellow index (YI) of less than or equal to about 3.5. In an embodiment, the cured product may satisfy a light transmittance of greater than or equal to about 85 %, a haze of less than or equal to about 1%, and a yellow index of less than or equal to about 2.0.

The cured product may be formed into a predetermined article.

The cured product may be, for example, formed into a film and thus used as a polymer film, and the polymer film may be transparent as aforementioned. The film may have, for example, a thickness ranging from about 0.1 microns (µm) to about 500 µm, about 1 µm to about 300 µm, about 1 µm to about 200 µm, or about 2 µm to about 150 µm. The film may have, for example, a light transmittance of greater than or equal to about 80 %, a haze of less than or equal to about 2%, and a yellow index of less than or equal to about 3.5, or a light transmittance of greater than or equal to about 85 %, a haze of less than or equal to about 1 %, and a yellow index of less than or equal to about 2.0.

The polymer film may be obtained by coating on a substrate and then, dried and cured.

Hereinafter, a window for an electronic device according to an embodiment is described.

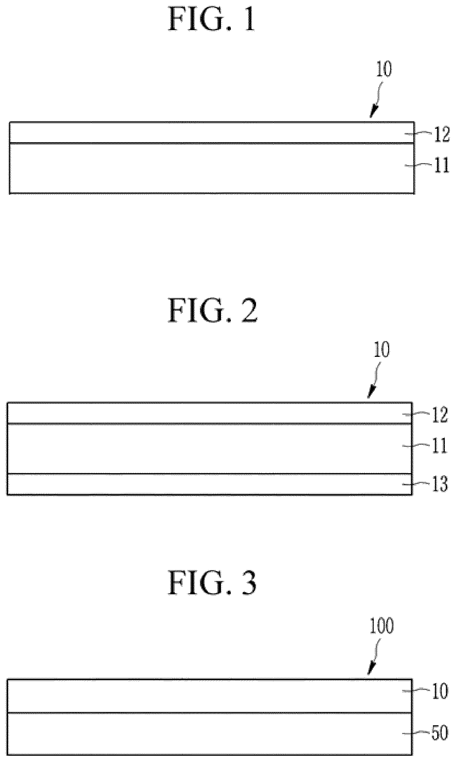

FIG. 1 is a cross-sectional view of a window for an electronic device according to an embodiment.

Referring to FIG. 1, a window 10 for an electronic device according to an embodiment includes a substrate 11 and a polymer film 12 disposed on the substrate 11.

The substrate 11 may be glass or a polymer substrate and may include, for example, a polyimide, polyamide, poly(amideimide), polyethylene terephthalate, polyethylene naphthalene, polymethyl(meth)acrylate, polycarbonate, a copolymer thereof, or a combination thereof, but is not limited thereto.

The substrate 11 may have, for example, a light transmittance of greater than or equal to about 85 % and a yellow index of less than or equal to about 3.0. The substrate 11 may have, for example, a thickness of about 25 µm to about 100 µm, for example about 30 µm to about 100 µm.

The polymer film 12 may be obtained by curing the above composition, for example, directly coating it on the substrate 11 and then drying and curing, or by coating the composition on a separate substrate (not shown) and then, drying and curing, and then separating the cured film from the separate substrate and transferring on the substrate 11.

The polymer film 12 may have, for example, a thickness ranging from about 0.1 µm to about 500 µm, about 1 µm to about 300 µm, about 1 µm to about 200 µm, or about 2 µm to about 150 µm.

The polymer film 12 may be disposed on the substrate 11 and may protect the window 10 from mechanical and/or physical damage. The polymer film 12 may be, for example, a hard coating layer or a scratch-resistant layer.

The window 10 includes the polymer film 12 obtained from the above composition and thus may improve its mechanical characteristics and flexibility, simultaneously. For example, the window 10 may have improved scratch resistance characteristics. For example, the window 10 may be bended, folded, or rolled so as to have a curvature radius (r) of for example less than or equal to 5 millimeters (mm), for example, less than or equal to 3 mm, less than or equal to 2 mm, or less than or equal to 1 mm.

In this way, the window 10 for an electronic device simultaneously satisfies desired mechanical characteristics and flexibility and thus may be effectively applied to an electronic device such as a bendable, foldable, or rollable display device.

FIG. 2 is a cross-sectional view of a window for an electronic device according to another embodiment.

Referring to FIG. 2, a window 10 for an electronic device according to an embodiment includes a substrate 11 and a polymer film 12, like the above embodiment shown in FIG. 1. However, the window 10 for an electronic device according to the present embodiment further includes a buffer layer 13 on the other side of the substrate 11. The buffer layer 13 faces the polymer film 12 with the substrate 11 in the middle. The buffer layer 13 is disposed beneath the substrate 11 and thus may absorb and/or buffer an impact delivered from the bottom of the substrate 11. Accordingly, when the window 10 is disposed on a display panel such as a liquid crystal panel or an organic light emitting panel, the window 10 may reduce or prevent delivery of an impact applied from the top of the window 10 toward the display panel and thus effectively protect the display device.

The window 10 for an electronic device may be applied to a variety of electronic devices. The electronic device may be, for example, a display device such as a liquid crystal display (LCD) or an organic light emitting diode (OLED) display, but is not limited thereto. The display device may be, for example, a bendable display device, a foldable display device, or a rollable display device.

The window 10 for an electronic device may be attached on the display panel. Herein, the display panel and window 10 for an electronic device may be bonded directly or through an adhesive or a glue.

FIG. 3 is a cross-sectional view of a display device according to an embodiment.

Referring to FIG. 3, a display device 100 according to an embodiment includes a display panel 50, a window 10, and an adhesion layer (not shown).

The display panel 50 may be for example an organic light emitting panel or a liquid crystal panel, for example a bendable display panel, a foldable display panel, or a rollable display panel.

The window 10 may be disposed on the side of an observer, and the structure thereof is the same as described above in FIGS. 1 and/or 2.

The display panel 50 and the window 10 may be bonded by an adhesion layer. The adhesion layer may include an adhesive or a glue, for example, an optical transparent adhesive (OCA). The adhesion layer may be omitted.

Between the display panel 50 and the window 10, another layer may be additionally disposed, for example, a single or plural polymer layer (not shown) and optionally, a transparent adhesion layer (not shown) may be included.

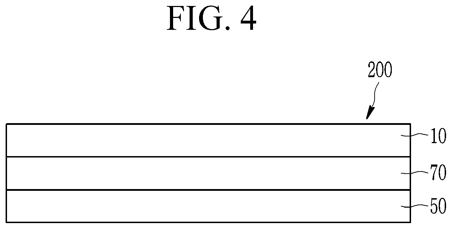

FIG. 4 is a cross-sectional view showing a display device according to another embodiment.

Referring to FIG. 4, a display device 200 according to the present embodiment includes a display panel 50, a window 10, and a touch panel 70 between the display panel 50 and the window 10.

The display panel 50 may be, for example, an organic light emitting diode panel or a liquid crystal panel, for example, a bendable display panel, a foldable display panel, or a rollable display panel.

The window 10 may be disposed toward an observer side, and the structure is the same as described above in FIGS. 1 and/or 2.

The touch panel 70 may be disposed between the window 10 and the display panel 50 to recognize the touched position and the position change when touched by a human hand or a material through the window 10 and then to output a touch signal. The driving module (not shown) may monitor a position where it is touched from the output touch signal; recognize an icon marked at the touched position; and control to carry out functions corresponding to the recognized icon, and the function performance results are displayed on the display panel 50.

Another layer may be interposed between the touch panel 70 and the window 10. For example, a single layer or plural layers of polymer layer (not shown) and optionally a transparent adhesion layer (not shown) may be further included.

The display device may be applied to a variety of electronic devices such as a smart phone, a tablet PC, a camera, a touch screen device, and the like, but is not limited thereto.

Hereinafter, exemplary embodiments are illustrated in more detail with reference to the examples. However, these examples are exemplary, and the present disclosure is not limited thereto.

### EXAMPLES

### Synthesis Examples

### Synthesis Example 1

20 mL of ethanol (Samchun Chemical) and 17.5 g of a 1 wt% tetramethylammonium hydroxide solution (Sigma-Aldrich Co., Ltd.) are put in a 100 mL double-jacket reaction bath and mixed. 26.5 mL of 3-glycidyloxypropyl)trimethoxysilane (Sigma-Aldrich Co., Ltd.) is added thereto, while mixing, and the obtained mixture is mixed at room temperature for 6 hours. Subsequently, the temperature is increased to 60 °C, and 40 mL of toluene (Sigma-Aldrich Co., Ltd.) is added thereto, and the obtained mixture is mixed for 6 hours. When the mixing is complete, the reaction product solution is washed with a saturated sodium chloride solution (Samchun Chemical), and the moisture still remaining therein is removed by using anhydrous sodium sulfate (Samchun Chemical). Subsequently, a solvent remaining in the reaction product, for example, toluene or the like, is removed by using an evaporator (Daihan Scientific Co., Ltd.) and a vacuum oven (Daihan Scientific Co., Ltd.). A structure of a synthesized final product is examined through proton nuclear magnetic resonance (¹H-NMR).

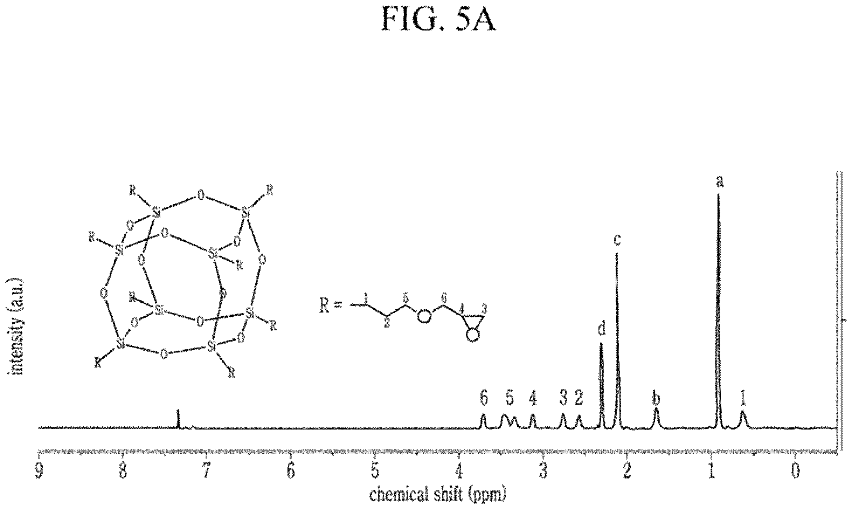

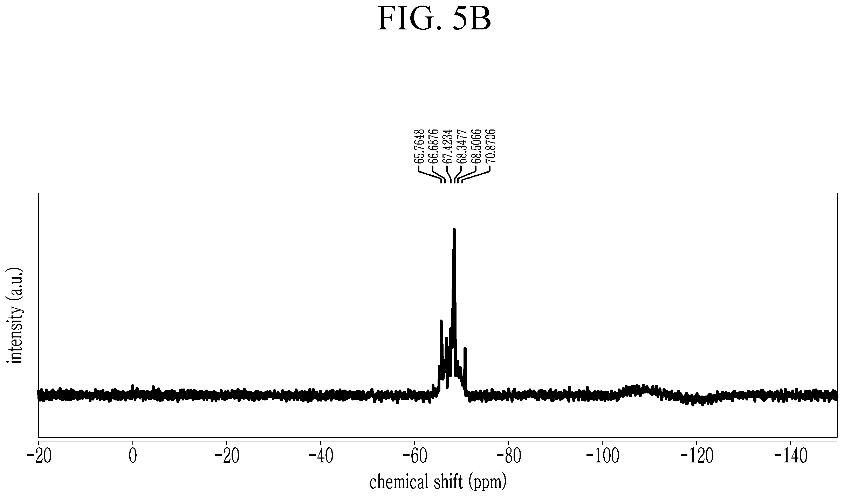

FIGS. 5A and 5B show ¹H-NMR and ²⁹Si-NMR spectra of the silsesquioxane obtained in Synthesis Example 1, respectively.

Referring to FIGS. 5A and 5B, the silsesquioxane according to Synthesis Example 1 is well synthesized to mainly have a reticular structure (T3).

### Synthesis Example 2

20 mL of ethanol (Samchun Chemical) and 17.5 g of a 1 wt% tetramethylammonium hydroxide solution (Sigma-Aldrich Co., Ltd.) are put in a 100 mL double jacket reaction bath and mixed. 18.2 mL of [8-(glycidyloxy)-n-octyl]trimethoxysilane (TCI) is added thereto, while mixing, and the obtained mixture is further mixed at room temperature for 6 hours. Subsequently, the temperature is increased to 60 °C, and 40 mL of toluene (Sigma-Aldrich Co., Ltd.) is added to the mixture, and the obtained mixture is mixed for 6 hours. When the mixing is complete, a reaction product solution is washed by using a saturated sodium chloride solution (Samchun Chemical), and the moisture remaining therein is removed by using anhydrous sodium sulfate (Samchun Chemical). A solvent such as toluene, or the like, that is remaining in the reaction product is removed by using an evaporator (Daihan Scientific Co., Ltd.) and a vacuum oven (Daihan Scientific Co., Ltd.). A structure of a final product synthesized therefrom is examined through ¹H-NMR.

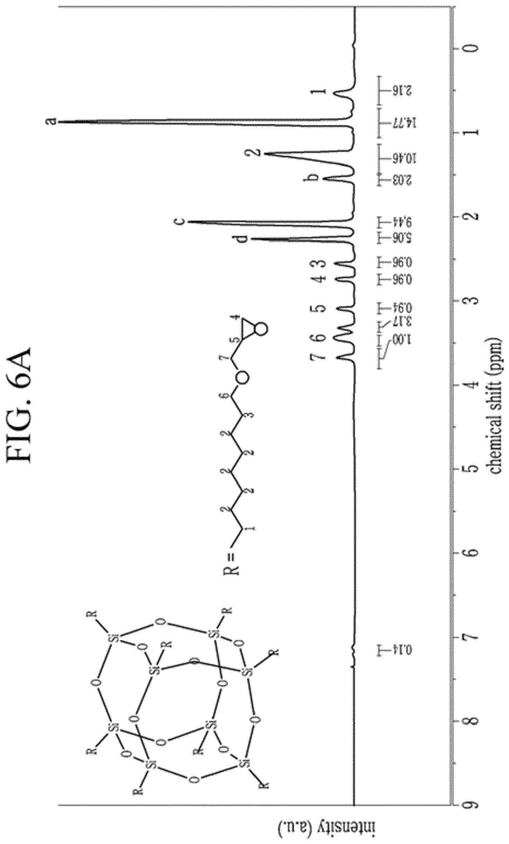

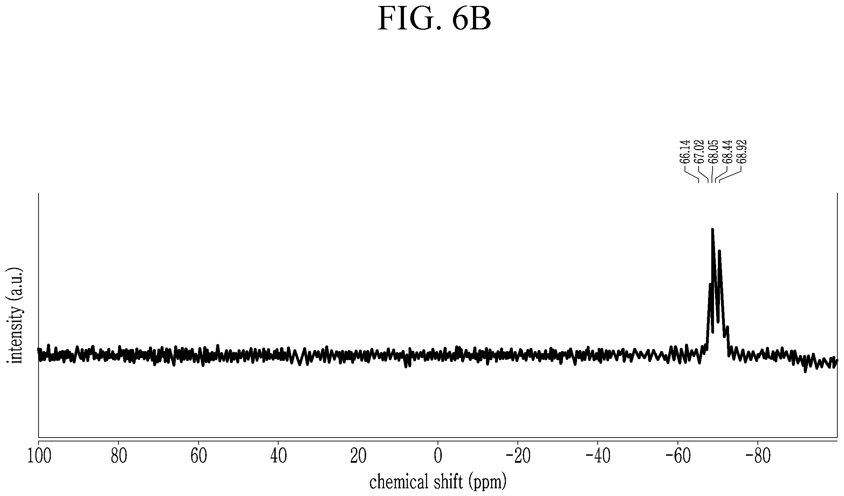

FIGS. 6A and 6B show ¹H-NMR and ²⁹Si-NMR spectra of silsesquioxane obtained in Synthesis Example 2.

Referring to FIGS. 6A and 6B, an asymmetric peak is additionally found at a chemical shift of about 1.54 ppm, unlike the NMR spectrum of FIGS. 5A and 5B. The peak corresponds to a chain in the middle of an organic functional group of [8-(glycidyloxy)-n-octyl]trimethoxysilane.

Referring to FIGS. 6A and 6B, the silsesquioxane according to Synthesis Example 2 is well synthesized to mainly have a reticular structure (T3).

### Preparation of Composition

### Preparation Example 1

The silsesquioxane according to Synthesis Example 1, the silsesquioxane according to Synthesis Example 2, and a cationic polymerizable organic compound represented by Chemical Formula A-1 in a weight ratio of 40:40:20 are added to methylisobutylketone, and the mixture is stirred. Herein, the silsesquioxane according to Synthesis Example 1, the silsesquioxane according to Synthesis Example 2, and a cationic polymerizable organic compound (solid) represented by Chemical Formula A-1 are used in an amount 50 wt% based on a total amount of a solution. Subsequently, 2 parts by weight of a cationic initiator (Irgacure 250, BASF Corp.) based on 100 parts by weight of the solid are added thereto, 0.1 parts by weight of a surface characteristic controller (KY-1203, Shin-Etsu Chemical Co., Ltd.) based on 100 parts by weight of the solid is added thereto, and the mixture is uniformly mixed to prepare a composition.

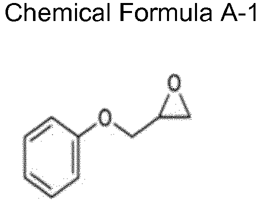

### Preparation Example 2

A composition is prepared according to the same method as Preparation Example 1 except for using a cationic polymerizable organic compound represented by Chemical Formula B-1 instead of the cationic polymerizable organic compound represented by Chemical Formula A-1.

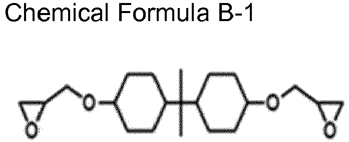

### Preparation Example 3

A composition is prepared according to the same method as Preparation Example 1 except for using a cationic polymerizable organic compound represented by Chemical Formula B-2 instead of the cationic polymerizable organic compound represented by Chemical Formula A-1.

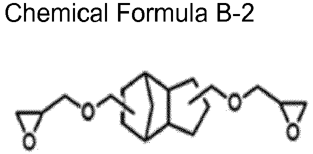

### Preparation Example 4

A composition is prepared according to the same method as Preparation Example 1 except for using the silsesquioxane according to Synthesis Example 1, the silsesquioxane according to Synthesis Example 2, and the cationic polymerizable organic compound represented by Chemical Formula A-1 in a weight ratio of 30:30:40.

### Preparation Example 5

A composition is prepared according to the same method as Preparation Example 1 except for using the silsesquioxane according to Synthesis Example 1, the silsesquioxane according to Synthesis Example 2, and the cationic polymerizable organic compound represented by Chemical Formula A-1 in a weight ratio of 50:30:20.

### Preparation Example 6

A composition is prepared according to the same method as Preparation Example 1 except for using the silsesquioxane according to Synthesis Example 1, the silsesquioxane according to Synthesis Example 2, and the cationic polymerizable organic compound represented by Chemical Formula A-1 in a weight ratio of 30:50:20.

### Comparative Preparation Example 1

A composition is prepared according to the same method as Preparation Example 1 except for using the silsesquioxane according to Synthesis Example 1 and the cationic polymerizable organic compound represented by Chemical Formula A-1 in a weight ratio of 80:20 without using the silsesquioxane according to Synthesis Example 2.

### Comparative Preparation Example 2

A composition is prepared according to the same method as Preparation Example 1 except for using the silsesquioxane according to Synthesis Example 1 and the cationic polymerizable organic compound represented by Chemical Formula A-1 in a weight ratio of 50:50 without using the silsesquioxane according to Synthesis Example 2.

### Comparative Preparation Example 3

A composition is prepared according to the same method as Preparation Example 1 except for using the silsesquioxane according to Synthesis Example 2 and the cationic polymerizable organic compound represented by Chemical Formula A-1 in a weight ratio of 80:20 without using the silsesquioxane according to Synthesis Example 1.

### Manufacture of Window

### Example 1

The composition according to Preparation Example 1 was bar-coated on an 80 µm-thick polyimide film, and a solvent is removed therefrom in a drying oven. Subsequently, the dried composition is cured by using a UV hardener (LC6B, Fusion UV Systems Inc.) with 100 to 500 mJ/cm² to form a 10 µm-thick polymer film and thus manufacture a window.

### Example 2

A window is manufactured according to the same method as Example 1 except for using the composition according to Preparation Example 2 instead of the composition according to Preparation Example 1.

### Example 3

A window is manufactured according to the same method as Example 1 except for using the composition according to Preparation Example 3 instead of the composition according to Preparation Example 1.

### Example 4

A window is manufactured according to the same method as Example 1 except for using the composition according to Preparation Example 4 instead of the composition according to Preparation Example 1.

### Example 5

A window is manufactured according to the same method as Example 1 except for using the composition according to Preparation Example 5 instead of the composition according to Preparation Example 1.

### Example 6

A window is manufactured according to the same method as Example 1 except for using the composition according to Preparation Example 6 instead of the composition according to Preparation Example 1.

### Comparative Example 1

A window is manufactured according to the same method as Example 1 except for using the composition according to Comparative Preparation Example 1 instead of the composition according to Preparation Example 1.

### Comparative Example 2

A window is manufactured according to the same method as Example 1 except for using the composition according to Comparative Preparation Example 2 instead of the composition according to Preparation Example 1.

### Comparative Example 3

A window is manufactured according to the same method as Example 1 except for using the composition according to Comparative Preparation Example 3 instead of the composition according to Preparation Example 1.

### Evaluation

Scratch resistance characteristics, flexibility, and optical characteristics of the windows according to Examples 1 to 6 and Comparative Examples 1 to 3 are evaluated.

The scratch resistance characteristics are evaluated by using a scuff test (COAD.108, Ocean Science).

The scratch resistance characteristics are evaluated by respectively fixing the windows according to Examples 1 to 6 and Comparative Examples 1 to 3 and then, putting a Φ20 cylinder wound by #0000 steel wool thereon. After putting a weight of 1.5 Kg on a weight connected with the cylinder, the weight connected with the cylinder is 10 times moved back and forth at a speed of 45 times/minute. Then, whether or not a scratch is formed on the surface of each window is examined with naked eyes.

The flexibility is evaluated by using a Mandrel tester (TQC B.V.) according to ISO1519. The Mandrel tester is mounted on each window, which is folded so as to have a radius of 1 mm and then fixed to apply a tensile stress to a polymer film of the window. Subsequently, the window is twice repetitively folded and unfolded, and whether or not a crack is made thereon is examined with naked eyes.

Light transmittance, haze, and a yellow index (YI) are measured by using a UV spectrometer (cm-3600d, KONICA MINOLTA Inc.), and herein, the haze is measured according to D1003-97(A), and the yellow index is measured according to D1925. The light transmittance, for example, indicates transmittance over all the visible ray regions ranging from about 380 nanometers (nm) to 700 nm.

In order to evaluate optical properties, the window is cut into a size of 50 mm^{∗}50 mm, and then, the transmittance and the yellow index are measured under a transmittance mode, and the haze is measured under a haze mode.

The results are shown in Table 1.

**Table 1**

| | Scratch resistance | Flexibility | Light transmittance (%) | Haze (%) | Yellow index (YI) |
|---|---|---|---|---|---|
| Example 1 | Pass | ⊚ | 90.7 | 0.6 | 0.9 |
| Example 2 | Pass | ⊚ | 90.6 | 0.5 | 0.9 |
| Example 3 | Pass | ⊚ | 90.7 | 0.6 | 0.8 |
| Example 4 | Pass | ⊚ | 90.5 | 0.6 | 0.9 |
| Example 5 | Pass | ⊚ | 90.7 | 0.7 | 0.7 |
| Example 6 | Pass | ⊚ | 90.5 | 0.6 | 0.9 |
| Comparative Example 1 | Pass | X | 90.4 | 0.8 | 1.0 |
| Comparative Example 2 | Fail | ⊚ | 90.7 | 0.6 | 0.7 |
| Comparative Example 3 | Fail | Δ | 90.6 | 0.7 | 0.9 |

| | | | | | |
|---|---|---|---|---|---|
| * Pass: No scratch when examined with naked eyes. * Fail: A plurality of scratch when examined with naked eyes. * ⊚: No crack where folded. * Δ: Partial crack where folded. * X: Whole crack where folded. | | | | | |

Referring to Table 1, the windows according to Examples 1 to 6 show improved scratch resistance characteristics and flexibility compared with the windows according to Comparative Examples 1 to 3.

While this disclosure has been described in connection with one or more example embodiments, it is to be understood that the disclosure is not limited to the exemplary embodiments, but, on the contrary, is intended to cover various modifications and equivalent arrangements made thereto without departing from the scope as defined by the following claims.

## Claims

1. A composition comprising
a cationic polymerizable organic compound; and
an organosiloxane comprising at least one silsesquioxane,
wherein each silsesquioxane independently comprises an inorganic core having a SiO_{3/2} moiety and an organic group having a cationic polymerizable functional group, and
wherein the organic group in the organosiloxane comprises a first organic group represented by Chemical Formula 1 and a second organic group represented by Chemical Formula 2,
Chemical Formula 1 R¹-(CH₂)ₙ₁-*
Chemical Formula 2 R²-(CH₂)ₙ₂-*
wherein, in Chemical Formula 1 or 2,
R¹ and R² are each independently the cationic polymerizable functional group,
n1 is an integer ranging from 1 to 3, and
n2 is an integer of 4 or greater.

2. The composition of claim 1, wherein the organosiloxane comprises
a first silsesquioxane comprising a first inorganic core having a SiO_{3/2} moiety, and the first organic group linked with the first inorganic core; and
a second silsesquioxane comprising a second inorganic core having a SiO_{3/2} moiety, and the second organic group linked with the second inorganic core;
preferably wherein the first silsesquioxane and the second silsesquioxane are in a weight ratio of 9:1 to 1:9.

3. The composition of claim 2, wherein the first silsesquioxane is represented by Chemical Formula 3, and
the second silsesquioxane is represented by Chemical Formula 4:
Chemical Formula 3 (R^{a}R^{b}R^{c}SiO_{1/2})_{M1}(R^{d}R^{e}SiO_{2/2})_{D1}(R^{f}SiO_{3/2})_{T1a}(R^{g}Sio_{3/2})_{T1b}(R^{h}SiO_{3/2})_{T1c}(SiO_{4/2})_{Q1}
Chemical Formula 4 (RⁱR^{j}R^{k}SiO_{1/2})_{M2}(R^{l}R^{m}SiO_{2/2})_{D2}(RⁿSiO_{3/2})_{T2a}(R^{o}SiO_{3/2})_{T2b}(R^{p}SiO_{3/2})_{T2c}(SiO_{4/2})_{Q2}
wherein, in Chemical Formula 3 and 4,
R^{a} to R^{g} and Rⁱ to R^{o} are each independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, a substituted or unsubstituted C1 to C30 alkoxy group, a substituted or unsubstituted C1 to C30 carbonyl-containing group, a hydroxy group, or a combination thereof,
R^{h} is the first organic group represented by Chemical Formula 1,
R^{p} is the second organic group represented by Chemical Formula 2,
0≤M1≤0.4, 0≤D1≤0.4, 0≤T1a<1, 0≤T1b<1, 0<T1c≤1, and 0≤Q1≤0.4, provided that 0.6≤T1a+T1b+T1c≤1,
0≤M2≤0.4, 0≤D2≤0.4, 0≤T2a<1, 0≤T2b<1, 0<T2c≤1, and 0≤Q2≤0.4, provided that 0.6≤T2a+T2b+T2c≤1,
M1+D1+T1a+T1b+T1c+Q1=1, and
M2+D2+T2a+T2b+T2c+Q2=1.

4. The composition of any of claims 1-3, wherein the organosiloxane comprises a silsesquioxane comprising a third inorganic core having a SiO_{3/2} moiety, and the first organic group and the second organic group each linked with the third inorganic core;
preferably wherein the silsesquioxane is represented by Chemical Formula 5:
Chemical Formula 5 (R^{q}R^{r}R^{s}SiO_{1/2})_{M3}(R^{t}R^{u}SiO_{2/2})_{D3}(R^{v}SiO_{3/2})_{T3a}(R^{w}SiO_{3/2})_{T3b}(R^{x}SiO_{3/2})_{T3c}(R^{y}SiO_{3/2})_{T3d} (SiO_{4/2})_{Q3}
wherein, in Chemical Formula 5,
R^{q} to R^{w} are each independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, a substituted or unsubstituted C1 to C30 alkoxy group, a substituted or unsubstituted C1 to C30 carbonyl-containing group, a hydroxy group, or a combination thereof,
R^{x} is the first organic group represented by Chemical Formula 1,
R^{y} is the second organic group represented by Chemical Formula 2, 0≤M3≤0.4, 0≤D3≤0.4, 0≤T3a<1, 0≤T3b<1, 0<T3c<1, 0<T3d<1, and 0≤Q3≤0.4, provided that 0.6≤T3a+T3b+T3c+T3d≤1, and
M3+D3+T3a+T3b+T3c+T3d+Q3=1.

5. The composition of any of claims 1-4, wherein the n1 of Chemical Formula 1 is 1, 2, or 3, and
the n2 of Chemical Formula 2 is an integer of 6 to 12.

6. The composition of any of claims 1-5, wherein the cationic polymerizable functional group includes a substituted or unsubstituted glycidyl group, a substituted or unsubstituted glycidyl ether group, a substituted or unsubstituted glycidyl ester group, a substituted or unsubstituted oxetanyl group, a substituted or unsubstituted C3 to C30 epoxyalkyl group, or a combination thereof.

7. The composition of any of claims 1-6, wherein the first organic group is represented by Chemical Formula 1a, and
the second organic group is represented by Chemical Formula 2a: 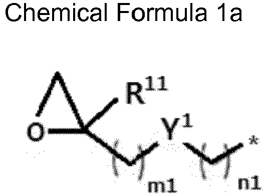 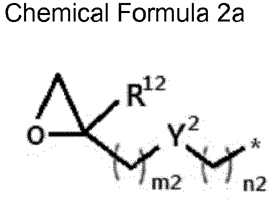 wherein, in Chemical Formula 1a or 2a,
Y¹ and Y² are each independently O, C(=O), C(=O)O, or OC(=O),
R¹¹ and R¹² are each independently hydrogen or a methyl group,
m1 and m2 are each independently an integer ranging from 1 to 3,
n1 is an integer ranging from 1 to 3, and
n2 is an integer of 4 or greater.

8. The composition of any of claims 1-7, wherein the cationic polymerizable organic compound comprises a substituted or unsubstituted glycidyl group, a substituted or unsubstituted glycidyl ether group, a substituted or unsubstituted glycidyl ester group, a substituted or unsubstituted oxetanyl group, a substituted or unsubstituted C3 to C30 epoxyalkyl group, a substituted or unsubstituted vinyl group, a substituted or unsubstituted vinyl ether group, a substituted or unsubstituted styrenyl group, or a combination thereof.

9. The composition of any of claims 1-8, wherein the cationic polymerizable organic compound is represented by Chemical Formula A or B: 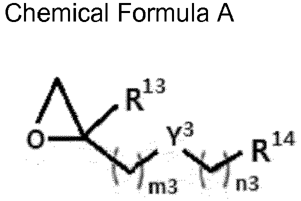 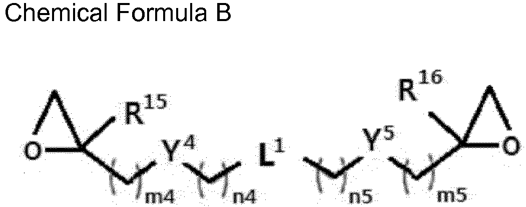 wherein, in Chemical Formula A or B,
Y³ to Y⁵ are each independently O, C(=O), C(=O)O, or OC(=O),
R¹³, R¹⁵, and R¹⁶ are each independently hydrogen or a methyl group,
R¹⁴ is a substituted or unsubstituted C1 to C30 alkyl group, a substituted or unsubstituted C3 to C30 cycloalkyl group, a substituted or unsubstituted C2 to C30 heterocycloalkyl group, a substituted or unsubstituted C6 to C30 aryl group, a substituted or unsubstituted C3 to C30 heteroaryl group, or a combination thereof,
L¹ is a substituted or unsubstituted C1 to C30 alkylene group, a substituted or unsubstituted C3 to C30 cycloalkylene group, a substituted or unsubstituted C2 to C30 heterocycloalkylene group, a substituted or unsubstituted C6 to C30 arylene group, a substituted or unsubstituted C3 to C30 heteroarylene group, or a combination thereof,
m3 to m5 are each independently an integer ranging from 1 to 3, and
n3 to n5 are each independently an integer ranging from 0 to 10.

10. The composition of any of claims 1-9, wherein an amount by weight of the organosiloxane is equal to or greater than an amount by weight of the cationic polymerizable organic compound.

11. The composition of any of claims 1-10, wherein the cationic polymerizable organic compound is in an amount of 5 parts by weight to 50 parts by weight, based on a total amount of 100 parts by weight of the cationic polymerizable organic compound and the organosiloxane, and
the organosiloxane is in an amount of 50 parts by weight to 95 parts by weight, based on a total amount of 100 parts by weight of the cationic polymerizable organic compound and the organosiloxane.

12. The composition of any of claims 1-11, further comprising a solvent, and
wherein a total amount of the cationic polymerizable organic compound and the organosiloxane may be 10 weight percent to 80 weight percent, based on a total weight of the composition;
preferably further comprising at least one of a reaction initiator, a fluorine compound, and a silicon-based compound.

13. An article or film comprising a cured product of the composition of any of claims 1-12.

14. A window for an electronic device, the window comprising
a polymer substrate; and
the film of claim 13 disposed on the polymer substrate.

15. An electronic device comprising the film of claim 13 or the window for the electronic device of claim 14.

## Patentansprüche

1. Zusammensetzung, die Folgendes umfasst:
eine kationische polymerisierbare organische Verbindung; und
ein Organosiloxan, das mindestens ein Silsesquioxan umfasst,
wobei jedes Silsesquioxan unabhängig einen anorganischen Kern mit einem SiO_{3/2}-Rest und eine organische Gruppe mit einer kationisch polymerisierbaren funktionellen Gruppe umfasst, und
wobei die organische Gruppe in dem Organosiloxan eine erste organische Gruppe, dargestellt von der Chemischen Formel 1, und eine zweite organische Gruppe, dargestellt von der Chemischen Formel 2, umfasst,
Chemische Formel 1 R¹-(CH₂)ₙ₁-*
Chemische Formel 2 R²-(CH₂)ₙ₂-*
wobei in der Chemischen Formel 1 oder 2
R¹ und R² jeweils unabhängig für die kationische polymerisierbare funktionelle Gruppe stehen,
n1 für eine ganze Zahl im Bereich von 1 bis 3 steht und
n2 für eine ganze Zahl von 4 oder mehr steht.

2. Zusammensetzung nach Anspruch 1, wobei das Organosiloxan Folgendes umfasst
ein erstes Silsesquioxan, das einen ersten anorganischen Kern mit einem SiO_{3/2}-Rest umfasst, und wobei die erste organische Gruppe mit dem ersten anorganischen Kern verknüpft ist; und
ein zweites Silsesquioxan, das einen zweiten anorganischen Kern mit einem SiO_{3/2}-Rest umfasst, und wobei die zweite organische Gruppe mit dem zweiten anorganischen Kern verknüpft ist; und
wobei vorzugsweise das erste Silsesquioxan und das zweite Silsesquioxan in einem Gewichtsverhältnis von 9 : 1 bis 1:9 vorliegen.

3. Zusammensetzung nach Anspruch 2, wobei das erste Silsesquioxan von der Chemischen Formel 3 dargestellt wird und
das zweite Silsesquioxan von der Chemischen Formel 4 dargestellt wird:
Chemische Formel 3 (R^{a}R^{b}R^{c}SiO_{1/2})_{M1}(R^{d}R^{e}SiO_{2/2})_{D1}(R^{f}SiO_{3/2})_{T1a}(R^{g}SiO_{3/2})_{T1b}(R^{h}SiO_{3/2})_{T1c}(SiO_{4/2})_{Q1}
Chemische Formel 4 (RⁱR^{j}R^{k}SiO_{1/2})_{M2}(R^{l}R^{m}SiO_{2/2})_{D2}(RⁿSiO_{3/2})_{T2a}(R^{o}SiO_{3/2})_{T2b}(R^{p}SiO_{3/2})_{T2c}(SiO_{4/2})_{Q2}
wobei in der Chemischen Formel 3 und 4
R^{a} bis R^{g} und Rⁱ bis R^{o} jeweils unabhängig für Wasserstoff, eine substituierte oder unsubstituierte C1-C30-Alkylgruppe, eine substituierte oder unsubstituierte C3-C30-Cycloalkylgruppe, eine substituierte oder unsubstituierte C6-C30-Arylgruppe, eine substituierte oder unsubstituierte C7-C30-Arylalkylgruppe, eine substituierte oder unsubstituierte C1-C30-Heteroalkylgruppe, eine substituierte oder unsubstituierte C2-C30-Heterocycloalkylgruppe, eine substituierte oder unsubstituierte C2-C30-Alkenylgruppe, eine substituierte oder unsubstituierte C2-C30-Alkinylgruppe, eine substituierte oder unsubstituierte C1-C30-Alkoxygruppe, eine substituierte oder unsubstituierte, Carbonyl enthaltende C1-C30-Gruppe, eine Hydroxygruppe oder eine Kombination davon stehen,
R^{h} für die erste organische Gruppe steht, die von der Chemischen Formel 1 dargestellt wird,
R^{p} für die zweite organische Gruppe steht, die von der Chemischen Formel 2 dargestellt wird,
0≤M1≤0,4, 0≤D1≤0,4, 0≤T1a<1, 0≤T1b<1, 0≤T1c≤1 und 0≤Q1≤0,4, vorausgesetzt, dass 0,6≤T1a+T1b+T1c≤1,
0≤M2≤0,4, 0≤D2≤0,4, 0≤T2a<1, 0≤T2b<1, 0<T2c≤1 und 0≤Q2≤0,4, vorausgesetzt, dass 0,6≤T2a+T2b+T2c≤1,
M1+D1+T1a+T1b+T1c+Q1=1 und
M2+D2+T2a+T2b+T2c+Q2=1.

4. Zusammensetzung nach einem der Ansprüche 1 bis 3, wobei das Organosiloxan ein Silsesquioxan umfasst, das einen dritten organischen Kern mit einem SiO_{3/2}-Rest umfasst, und wobei die erste organische Gruppe und die zweite organische Gruppe jeweils mit dem dritten anorganischen Kern verknüpft sind;
wobei das Silsesquioxan vorzugsweise von der Chemischen Formel 5 dargestellt wird:
Chemische Formel 5 (R^{q}R^{r}R^{s}SiO_{1/2})_{M3}(R^{t}R^{u}SiO_{2/2})_{D3}(R^{v}SiO_{3/2})_{T3a}(R^{w}SiO_{3/2})_{T3b}(R^{x}SiO_{3/2})_{T3c}(R^{y}SiO_{3/2})_{T3d}(SiO_{4/2})_{Q3}
wobei in der Chemischen Formel 5
R^{q} bis R^{w} jeweils unabhängig für Wasserstoff, eine substituierte oder unsubstituierte C1-C30-Alkylgruppe, eine substituierte oder unsubstituierte C3-C30-Cycloalkylgruppe, eine substituierte oder unsubstituierte C6-C30-Arylgruppe, eine substituierte oder unsubstituierte C7-C30-Arylalkylgruppe, eine substituierte oder unsubstituierte C1-C30-Heteroalkylgruppe, eine substituierte oder unsubstituierte C2-C30-Heterocycloalkylgruppe, eine substituierte oder unsubstituierte C2-C30-Alkenylgruppe, eine substituierte oder unsubstituierte C2-C30-Alkinylgruppe, eine substituierte oder unsubstituierte C1-C30-Alkoxygruppe, eine substituierte oder unsubstituierte, Carbonyl enthaltende C1-C30-Gruppe, eine Hydroxygruppe oder eine Kombination davon stehen,
R^{x} für die erste organische Gruppe steht, die von der Chemischen Formel 1 dargestellt wird,
R^{y} für die zweite organische Gruppe steht, die von der Chemischen Formel 2 dargestellt wird,
0≤M3≤0,4, 0≤D3<0,4, 0≤T3a<1, 0≤T3b<1, O<T3c<1, 0<T3d<1 und 0≤Q3≤0,4, vorausgesetzt, dass 0,6≤T3a+T3b+T3c+T3d≤1 und
M3+D3+T3a+T3b+T3c+T3d+Q3=1.

5. Zusammensetzung nach einem der Ansprüche 1 bis 4, wobei n1 der Chemischen Formel 1 für 1, 2 oder 3 steht und
n2 der Chemischen Formel 2 für eine ganze Zahl von 6 bis 12 steht.

6. Zusammensetzung nach einem der Ansprüche 1 bis 5, wobei die kationische polymerisierbare funktionelle Gruppe eine substituierte oder unsubstituierte Glycidylgruppe, eine substituierte oder unsubstituierte Glycidylethergruppe, eine substituierte oder unsubstituierte Glycidylestergruppe, eine substituierte oder unsubstituierte Oxetanylgruppe, eine substituierte oder unsubstituierte C3-C30-Epoxyalkylgruppe oder eine Kombination davon enthält.

7. Zusammensetzung nach einem der Ansprüche 1 bis 6, wobei die erste organische Gruppe von der Chemischen Formel 1a dargestellt wird und
die zweite organische Gruppe von der Chemischen Formel 2a dargestellt wird: 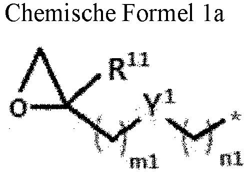 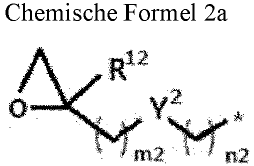 wobei in der Chemischen Formel 1a oder 2a
Y¹ und Y² jeweils unabhängig für O, C(=O), C(=O)O oder OC(=O) stehen,
R¹¹ und R¹² jeweils unabhängig für Wasserstoff oder eine Methylgruppe stehen,
m1 und m2 jeweils unabhängig für eine ganze Zahl im Bereich von 1 bis 3 stehen,
n1 für eine ganze Zahl im Bereich von 1 bis 3 steht und
n2 für eine ganze Zahl von 4 oder mehr steht.

8. Zusammensetzung nach einem der Ansprüche 1 bis 7, wobei die kationische polymerisierbare organische Verbindung eine substituierte oder unsubstituierte Glycidylgruppe, eine substituierte oder unsubstituierte Glycidylethergruppe, eine substituierte oder unsubstituierte Glycidylestergruppe, eine substituierte oder unsubstituierte Oxetanylgruppe, eine substituierte oder unsubstituierte C3-C30-Epoxyalkylgruppe, eine substituierte oder unsubstituierte Vinylgruppe, eine substituierte oder unsubstituierte Vinylethergruppe, eine substituierte oder unsubstituierte Styrenylgruppe oder eine Kombination davon umfasst.

9. Zusammensetzung nach einem der Ansprüche 1 bis 8, wobei die kationische polymerisierbare organische Verbindung von der Chemischen Formel A oder B dargestellt wird: 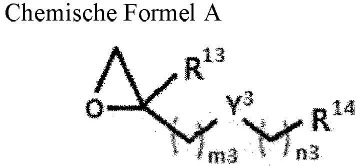 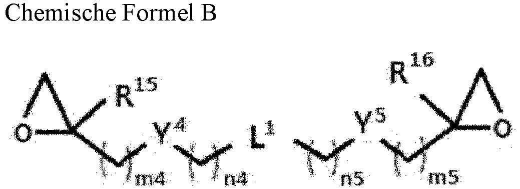 wobei in der Chemischen Formel A oder B
Y³ bis Y⁵ jeweils unabhängig für O, C(=O), C(=O)O oder OC(=O) stehen,
R¹³, R¹⁵ und R¹⁶ jeweils unabhängig für Wasserstoff oder eine Methylgruppe stehen,
R¹⁴ für eine substituierte oder unsubstituierte C1-C30-Alkylgruppe, eine substituierte oder unsubstituierte C3-C30-Cycloalkylgruppe, eine substituierte oder unsubstituierte C2-C30-Heterocycloalkylgruppe, eine substituierte oder unsubstituierte C6-C30-Arylgruppe, eine substituierte oder unsubstituierte C3-C30-Heteroarylgruppe oder eine Kombination davon steht,
L¹ für eine substituierte oder unsubstituierte C1-C30-Alkylengruppe, eine substituierte oder unsubstituierte C3-C30-Cycloalkylengruppe, eine substituierte oder unsubstituierte C2-C30-Heterocycloalkylengruppe, eine substituierte oder unsubstituierte C6-C30-Arylengruppe, eine substituierte oder unsubstituierte C3-C30-Heteroarylengruppe oder eine Kombination davon steht,
m3 bis m5 jeweils unabhängig für eine ganze Zahl im Bereich von 1 bis 3 stehen und
n3 bis n5 jeweils unabhängig für eine ganze Zahl im Bereich von 0 bis 10 stehen.

10. Zusammensetzung nach einem der Ansprüche 1 bis 9, wobei eine Gewichtsmenge des Organosiloxans gleich einer oder größer als eine Gewichtsmenge der kationischen polymerisierbaren organischen Verbindung ist.

11. Zusammensetzung nach einem der Ansprüche 1 bis 10, wobei die kationische polymerisierbare organische Verbindung in einer Menge von 5 Gewichtsteilen bis 50 Gewichtsteilen, bezogen auf eine Gesamtmenge von 100 Gewichtsteilen der kationischen polymerisierbaren organischen Verbindung und des Organosiloxans, vorliegt und
wobei das Organosiloxan in einer Menge von 50 Gewichtsteilen bis 95 Gewichtsteilen, bezogen auf eine Gesamtmenge von 100 Gewichtsteilen der kationischen polymerisierbaren organischen Verbindung und des Organosiloxans, vorliegt.

12. Zusammensetzung nach einem der Ansprüche 1 bis 11, die ferner ein Lösungsmittel umfasst und
wobei eine Gesamtmenge der kationischen polymerisierbaren organischen Verbindung und des Organosiloxans 10 Gewichtsprozent bis 80 Gewichtsprozent, basierend auf einem Gesamtgewicht der Zusammensetzung, betragen kann;
und die vorzugsweise ferner einen Reaktionsinitiator und/oder eine Fluorverbindung und/oder eine Verbindung auf Siliciumbasis umfasst.

13. Artikel oder Folie, der bzw. die ein gehärtetes Produkt der Zusammensetzung nach einem der Ansprüche 1 bis 12 umfasst.

14. Fenster für eine elektronische Vorrichtung, wobei das Fenster ein Polymersubstrat umfasst; und
die Folie nach Anspruch 13, auf dem Polymersubstrat angeordnet.

15. Elektronische Vorrichtung, die die Folie nach Anspruch 13 oder das Fenster für die elektronische Vorrichtung nach Anspruch 14 umfasst.

## Revendications

1. Composition comprenant :
un composé organique polymérisable cationique ; et
un organosiloxane comprenant au moins un silsesquioxane,
chaque silsesquioxane comprenant indépendamment un noyau inorganique comportant une fraction SiO_{3/2} et un groupe organique comportant un groupe fonctionnel polymérisable cationique, et
ledit groupe organique dans l'organosiloxane comprenant un premier groupe organique représenté par la formule chimique 1 et un second groupe organique représenté par la formule chimique 2,
Formule chimique 1 R¹-(CH₂)ₙ₁-*
Formule chimique 2 R²-(CH₂)ₙ₂-*
dans lesquelles, dans la formule chimique 1 ou 2,
R¹ et R² représentent chacun indépendamment le groupe fonctionnel polymérisable cationique,
n1 représente un entier allant de 1 à 3, et
n2 représente un entier supérieur ou égal à 4.

2. Composition selon la revendication 1, ledit organosiloxane comprenant
un premier silsesquioxane comprenant un premier noyau inorganique comportant une fraction SiO_{3/2} et le premier groupe organique étant lié au premier noyau inorganique ; et
un second silsesquioxane comprenant un second noyau inorganique comportant une fraction SiO_{3/2} et le second groupe organique étant lié au second noyau inorganique ;
de préférence ledit premier silsesquioxane et ledit second silsesquioxane étant présents dans un rapport massique de 9 : 1 à 1:9.

3. Composition selon la revendication 2, ledit premier silsesquioxane étant représenté par la formule chimique 3, et
ledit second silsesquioxane étant représenté par la formule chimique 4 :
Formule chimique 3 (R^{a}R^{b}R^{c}SiO_{1/2})_{M1}(R^{d}R^{e}SiO_{2/2})_{D1}(R^{f}SiO_{3/2})_{T1a}(R^{g}SiO_{3/2})_{T1b}(R^{h}SiO_{3/2})_{T1c}(SiO_{4/2})_{Q1}
Formule chimique 4 (RⁱR^{j}R^{k}SiO_{1/2})_{M2}(R^{l}R^{m}SiO_{2/2})_{D2}(RⁿSiO_{3/2})_{T2a}(R^{o}SiO_{3/2})_{T2b}(R^{p}SiO_{3/2})_{T2c}(SiO_{4/2})_{Q2}
dans lesquelles, dans les formules chimiques 3 et 4,
R^{a} à R^{g} et Rⁱ à R^{o} représentent chacun indépendamment un atome d'hydrogène, un groupe alkyle en C1 à C30 substitué ou non substitué, un groupe cycloalkyle en C3 à C30 substitué ou non substitué, un groupe aryle en C6 à C30 substitué ou non substitué, un groupe arylalkyle en C7 à C30 substitué ou non substitué, un groupe hétéroalkyle en C1 à C30 substitué ou non substitué, un groupe hétérocycloalkyle en C2 à C30 substitué ou non substitué, un groupe alcényle en C2 à C30 substitué ou non substitué, un groupe alcynyle en C2 à C30 substitué ou non substitué, un groupe alcoxy en C1 à C30 substitué ou non substitué, un groupe contenant un groupe carbonyle en C1 à C30 substitué ou non substitué, un groupe hydroxy ou une combinaison de ceux-ci,
R^{h} représente le premier groupe organique représenté par la formule chimique 1,
R^{p} représente le second groupe organique représenté par la formule chimique 2, 0≤M1≤0,4, 0≤D1≤0,4, 0≤T1a<1, 0≤T1b<1, 0≤T1c≤1 et 0≤Q1≤0,4, à condition que 0,6≤T1a+T1b+T1c≤1,
0≤M2≤0,4, 0≤D2≤0,4, 0≤T2a<1, 0≤T2b<1, 0<T2c≤1, et 0≤Q2≤0,4, à condition que 0,6≤T2a+T2b+T2c≤1,
M1+D1+T1a+T1b+T1c+Q1=1, et
M2+D2+T2a+T2b+T2c+Q2=1.

4. Composition selon l'une quelconque des revendications 1 à 3, ledit organosiloxane comprenant un silsesquioxane comprenant un troisième noyau inorganique comportant une fraction SiO_{3/2}, et le premier groupe organique et le second groupe organique étant chacun liés au troisième noyau inorganique ;
de préférence ledit silsesquioxane étant représenté par la formule chimique 5 :
Formule chimique 5 (R^{q}R^{r}R^{s}SiO_{1/2})_{M3}(R^{t}R^{u}SiO_{2/2})_{D3}(R^{v}SiO_{3/2})_{T3a}(R^{w}SiO_{3/2})_{T3b}(R^{x}SiO_{3/2})_{T3c}(R^{y}SiO_{3/2})_{T3d}(SiO_{4/ 2})_{Q3}
dans laquelle, dans la formule chimique 5,
R^{q} à R^{w} représentent chacun indépendamment un atome d'hydrogène, un groupe alkyle en C1 à C30 substitué ou non substitué, un groupe cycloalkyle en C3 à C30 substitué ou non substitué, un groupe aryle en C6 à C30 substitué ou non substitué, un groupe arylalkyle en C7 à C30 substitué ou non substitué, un groupe hétéroalkyle en C1 à C30 substitué ou non substitué, un groupe hétérocycloalkyle en C2 à C30 substitué ou non substitué, un groupe alcényle en C2 à C30 substitué ou non substitué, un groupe alcynyle en C2 à C30 substitué ou non substitué, un groupe alcoxy en C1 à C30 substitué ou non substitué, un groupe contenant un groupe carbonyle en C1 à C30 substitué ou non substitué, un groupe hydroxy ou une combinaison de ceux-ci,
R^{x} représente le premier groupe organique représenté par la formule chimique 1,
R^{y} représente le second groupe organique représenté par la formule chimique 2,
0≤M3≤0,4, 0≤D3≤0,4, 0≤T3a<1, 0≤T3b<1, 0<T3c<1, 0<T3d<1 et 0≤Q3≤0,4, à condition que 0,6≤T3a+T3b+T3c+T3d≤1, et
M3+D3+T3a+T3b+T3c+T3d+Q3=1.

5. Composition selon l'une quelconque des revendications 1 à 4, n1 de la formule chimique 1 valant 1, 2 ou 3 et
n2 de la formule chimique 2 représentant un entier de 6 à 12.

6. Composition selon l'une quelconque des revendications 1 à 5, ledit groupe fonctionnel polymérisable cationique comportant un groupe glycidyle substitué ou non substitué, un groupe éther glycidylique substitué ou non substitué, un groupe ester de glycidyle substitué ou non substitué, un groupe oxétanyle substitué ou non substitué, un groupe époxyalkyle en C3 à C30 substitué ou non substitué, ou une combinaison de ceux-ci.

7. Composition selon l'une quelconque des revendications 1 à 6, ledit premier groupe organique étant représenté par la formule chimique la, et
ledit second groupe organique étant représenté par la formule chimique 2a : 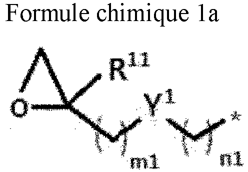 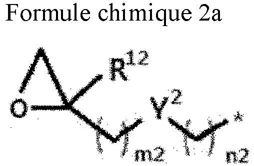 dans lesquelles, dans la formule chimique la ou 2a,
Y¹ et Y² représentent chacun indépendamment un atome O, un groupe C(=O), C(=O)O ou OC(=O),
R¹¹ et R¹² représentent chacun indépendamment un atome d'hydrogène ou un groupe méthyle,
m1 et m2 représentent chacun indépendamment un entier allant de 1 à 3,
n1 représente un entier allant de 1 à 3, et
n2 représente un entier supérieur ou égal à 4.

8. Composition selon l'une quelconque des revendications 1 à 7, ledit composé organique polymérisable cationique comprenant un groupe glycidyle substitué ou non substitué, un groupe éther glycidylique substitué ou non substitué, un groupe ester de glycidyle substitué ou non substitué, un groupe oxétanyle substitué ou non substitué, un groupe époxyalkyle en C3 à C30 substitué ou non substitué, un groupe vinyle substitué ou non substitué, un groupe éther vinylique substitué ou non substitué, un groupe styrényle substitué ou non substitué, ou une combinaison de ceux-ci.

9. Composition selon l'une quelconque des revendications 1 à 8, ledit composé organique polymérisable cationique étant représenté par la formule chimique A ou B : 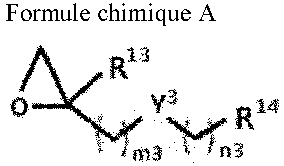 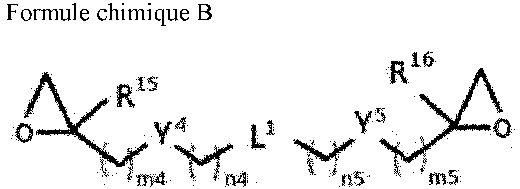 dans lesquelles, dans la formule chimique A ou B,
Y³ à Y⁵ représentent chacun indépendamment un atome O, un groupe C(=O), C(=O)O ou OC(=O),
R¹³, R¹⁵ et R¹⁶ représentent chacun indépendamment un atome d'hydrogène ou un groupe méthyle,
R¹⁴ représente un groupe alkyle en C1 à C30 substitué ou non substitué, un groupe cycloalkyle en C3 à C30 substitué ou non substitué, un groupe hétérocycloalkyle en C2 à C30 substitué ou non substitué, un groupe aryle en C6 à C30 substitué ou non substitué, un groupe hétéroaryle en C3 à C30 substitué ou non substitué, ou une combinaison de ceux-ci,
L¹ représente un groupe alkylène en C1 à C30 substitué ou non substitué, un groupe cycloalkylène en C3 à C30 substitué ou non substitué, un groupe hétérocycloalkylène en C2 à C30 substitué ou non substitué, un groupe arylène en C6 à C30 substitué ou non substitué, un groupe hétéroarylène en C3 à C30 substitué ou non substitué, ou une combinaison de ceux-ci,
m3 à m5 représentent chacun indépendamment un entier allant de 1 à 3, et
n3 à n5 représentent chacun indépendamment un entier allant de 0 à 10.

10. Composition selon l'une quelconque des revendications 1 à 9, la quantité en poids de l'organosiloxane étant supérieure ou égale à la quantité en poids du composé organique polymérisable cationique.

11. Composition selon l'une quelconque des revendications 1 à 10, ledit composé organique polymérisable cationique étant présent en une quantité de 5 parties en poids à 50 parties en poids, rapportée à la quantité totale de 100 parties en poids du composé organique polymérisable cationique et de l'organosiloxane, et
l'organosiloxane est présent en une quantité de 50 parties en poids à 95 parties en poids, rapportée à la quantité totale de 100 parties en poids du composé organique polymérisable cationique et de l'organosiloxane.

12. Composition selon l'une quelconque des revendications 1 à 11, comprenant en outre un solvant, et
la quantité totale du composé organique polymérisable cationique et de l'organosiloxane pouvant représenter 10 pour cent en poids à 80 pour cent en poids, rapportée au poids total de la composition ;
de préférence comprenant en outre au moins l'un parmi un initiateur de réaction, un composé de fluore et un composé à base de silicium.

13. Article ou film comprenant un produit durci de la composition selon l'une quelconque des revendications 1 à 12.

14. Fenêtre pour un dispositif électronique, la fenêtre comprenant
un substrat polymère ; et
le film selon la revendication 13 disposé sur le substrat polymère.

15. Dispositif électronique comprenant le film selon la revendication 13 ou la fenêtre pour le dispositif électronique selon la revendication 14.
